Europäisches Patentamt

European Patent Office

Office européen des brevets

(11) Publication number: **0 350 557 B1**

## EUROPEAN PATENT SPECIFICATION

(45) Date of publication of patent specification: **03.02.93**  (51) Int. Cl.⁵: **G01R 13/34**, H03M 7/30

(21) Application number: **88810477.5**

(22) Date of filing: **12.07.88**

⑤④ Method and apparatus for compacting digital time series data for display on a digital oscilloscope.

(43) Date of publication of application:
**17.01.90 Bulletin 90/03**

(45) Publication of the grant of the patent:
**03.02.93 Bulletin 93/05**

(84) Designated Contracting States:
**DE FR GB**

(56) References cited:
**US-A- 4 110 564**
**US-A- 4 669 097**

**EDN MAGAZINE, vol. 26, no. 4, 18.02.81, pages 115-118, New Application Technology, Boston, Massachusetts, US, TH: DAGOSTINO et al.: "Catch glitches on slow sweeps with scope's envelope mode"**

(73) Proprietor: **LE CROY S.A.**
**Route du Nant-d'Avril 101**
**CH-1217 Meyrin 1(CH)**

(72) Inventor: **Hungerbühler, Viktor M.**
**c/o Le Croy S.A. Route du Nant-d'Avril 101**
**CH-1217 Meyrin(CH)**

(74) Representative: **Reverdin, André Pierre**
**c/o Katzarov S.A. 19, Rue des Epinettes**
**CH-1227 Genève(CH)**

**Description**

The present invention relates to a method and an apparatus for compacting digital data, in particular for compacting digital time series data to be displayed on a display screen of a digital oscilloscope or transient recorder, when the number of data points available is larger than the horizontal resolution of the display screen.

Important applications of digital oscilloscopes involve the data acquisition for and display of high speed phenomena, for example in the areas of particle physics and the study of transient phenomena in electric power systems. High-speed data acquisition equipment samples the physical process and converts the sampled data into digital form. This data is stored in a memory as the original time series data. The number of data points, $N$, may typically go up to $100'000$. This data has to be displayed on the display screen of the digital oscilloscope whose horizontal resolution allows the display of a maximum of $M$ data points where $M$ is typically around 1000.

The general problem therefore is to display time series data of $N$ data points on a display screen with resolution $M$, where $N$ is significantly larger than $M$. Typically, $N/M = L = 4\text{-}100$.

Known in the state in the art are two methods to handle this problem, both of which have major drawbacks:

1) $M$, i.e. about 1000, out of $N$, i.e. $100'000$, datapoints are shown by using only the values of the data points $i, i+L, i+2L, i+3L,...,i+(M-1)L$. Thus, only 1 out of $L$ measured values is shown, the recorded data between the displayed datapoints are simply dropped. This method has the severe drawback that and interesting phenomenon between the displayed points is not shown. Short but significant value excursions may be totally missed. The method may also give rise to so-called 'aliasing' effects. Another way of expressing this is to say that the maximum observable frequency, the so-called Nyquist frequency, is reduced by a factor of $L$, greatly reducing the usefulness of the instrument.

2) The values shown are $j, j+1, j+2,...,j+M-1$, where $M$ is again about 1000. Only $M$ consecutive datapoints are shown at a given time, but the user has the possibility to choose the starting point $j$, for example with a knob, so that he can scroll through the data record from beginning to end.

This method does not distort the date, i.e. there are no 'aliasing' effects, but it has the drawback that only a small portion of the data can be inspected at a time, making a visual analysis of the total signal very tedious, especially if short random value excursions have to be looked for or if there is a good chance that the whole record does not contain any significant data.

Another method of data compression which retains maximum and minimum data values is disclosed in US-A-4,669,097, in which sequences of consecutive date points are replaced by their initial and their final data point, as long as the condition holds that these consecutive data points lie in a linear band of a given width. The drawback of this method is that the data reduction effect cannot be a priori known.

The problem therefore is to find a data compacting method which provides a display of the whole data record and of all significant value excursions, while guaranteeing a data reduction factor of $L = N/M$.

More precisely, the problem is to provide a method and an apparatus for data compacting of a $N$ data point signal for display on a display screen with horizontal resolution $M$ where $M$ is significantly smaller than $N$, so that the entire signal length and all significant maximum and minimum excursions, so-called 'glitches', will be displayed, no 'aliasing' introduced, and the displayed signal form closely approximates the display which would be obtained if all points could be displayed.

It is therefore an object of this invention as claimed to provide for a method and for an apparatus in a digital oscilloscope of compacting digital time series data of one resolution, $N$, to another resolution, $M$, compatible with the resolution of the display screen of the oscilloscope.

In accordance with the invention, the method comprises the steps of grouping the original $N$ data points in an acquisition memory into $M$ groups $G_j$, $j = 1,...,M$, of $L$ contiguous data points each, where $M^*L = N$, determining for each group $G_j$ the maximum and minimum values, $max_j$ and $min_j$, and storing them as a pair of values, $p_j$, in an auxiliary memory, selecting from the $M$ pairs $p_j$, $j = 1, ...,M$ in the auxiliary memory $M$ display values $e_j$, $j = 1,...,M$, for storage in a display image memory and display on the $M$ resolution display screen, so that the $M$ values include all extreme value excursions of the original data and represent the original signal essentially undistorted. The advantage of the inventive method is to guarantee that all extreme value excursions are determined and available for display and that the displayed signal closely resembles the original signal.

In a preferred implementation of the invention, the selection step consists of iteratively considering the values of $k1$ pairs of max/min values, $p_i,.. ,p_{i+k1-1}$, where $k1$ is at least 2, from the auxiliary memory, and of $k2$ of the most recently stored display values $e_{i-k2},...,e_{i-1}$, where $k2$ is at least 1, in the display image memory, and based thereon choosing $k1$ display variables, $e_i,...,e_{i+k1-1}$, from the $2^*k1$ values read from the auxiliary memory and storing them in the display image memory, and repeating these steps, for $j = 1, 1 + k1, ...., M-k1 + 1$, until the display image memory is filled.

In further preferred embodiments, k1 is equal to 2, and k2 is equal to 1, and $e_i$ and $e_{i+1}$ are obtained according to methods described in any of the claims 3 or 4.

Any of these methods of choosing the display variables $e_i$ insures that no extremum is left out. In addition, if the signal to be displayed is smooth and monotonous, the choice is such that the display becomes smooth.

The invention also provides for an apparatus to implement the inventive method, the apparatus comprising a data acquisi tion memory, data compaction means, a display image memory and a display screen, the apparatus being characterized by the data compaction means comprising a control unit, a max-min calculator to determine maxima and minima of M subgroups of the N data data in the data acquisition memory, an auxiliary memory for storing pairwise the maximum and the minimum of each subgroup, and a selector means for iteratively selecting from the M pairs in the auxiliary memory M display values to be stored in the display image memory, the max-min calculator, the auxiliary memory and the selector means connected over a data bus and a control bus to each other and to the data acquisition memory and the display image memory, the control unit connected to the control bus.

Further advantageous embodiments of the inventive apparatus are described in dependent claims 6-11.

The invention is now described more in detail on the basis of Fig. 1-3.

Fig. 1 gives an overview of the inventive apparatus

Fig. 2 shows a preferred embodiment of the max/min comparator, and

Fig. 3 shows the logic flow of the inventive method in its preferred realization.

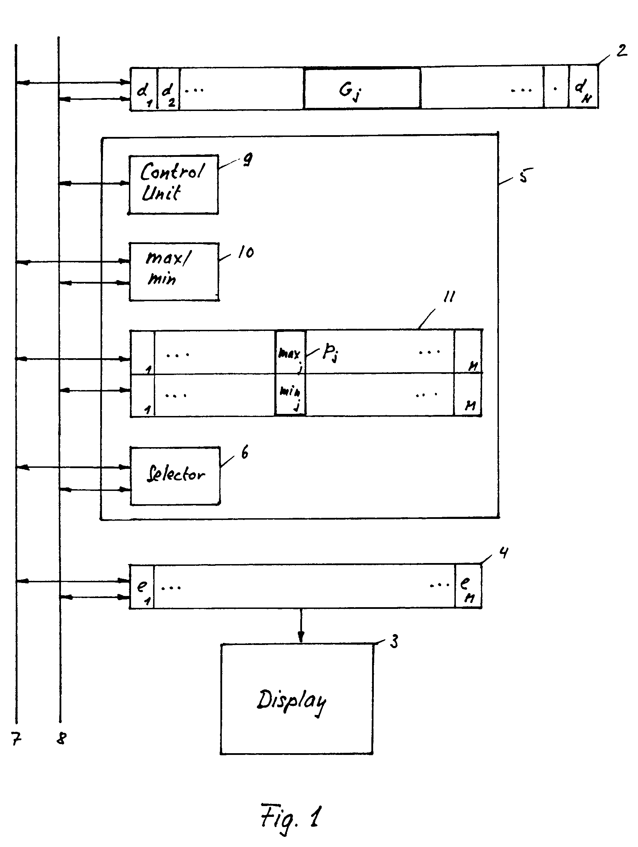

Referring to Fig.1, there are schematically shown the components of a digital oscilloscope which concern this invention. Through a data acquisition input port (not shown) original time series data, comprising N data points, are entered into the data acquisition memory 2, comprising N locations. This data is to be displayed in compacted form on the display screen 3 which receives its input from the display image memory 4. Since the display screen 3 allows for a horizontal resolution M, the display image memory 4 has M memory locations. The number of bytes per location is in accordance with the required vertical resolution of the display. The actual display can be a raster display or a vector display, although for better quality of the display of the signal form vector graphic displays are preferred.

A data compaction means 5 is connected to the data acquisition memory 2 and the display image memory 4 over a data bus 7 and a control bus 8.

As the data compaction is carried out under the supervision of a control unit 9, the original data is divided into M subgroups $G_j, j = 1,...,M$. For each subgroup the L data points are sequentially transferred to a max-min calculator 10, which determines the maximum, $max_j$, and the minimum, $min_j$, of the L data points in $G_j$. $max_j$ and $min_j$ are then stored in the j-th location pair of an auxiliary memory 11.

In a second part of the compaction method, the M locations of the display image memory 4 are iteratively filled by the selector means 6, by considering the values of k1 max-min pairs at a time from the auxiliary memory 11 and of k2 of the most recently stored values in the display image memory 4 and by determining, based on these values, which k1 values of the 2*k1 values read from the auxiliary memory 11 should be stored in the display image memory 4, and in which order.

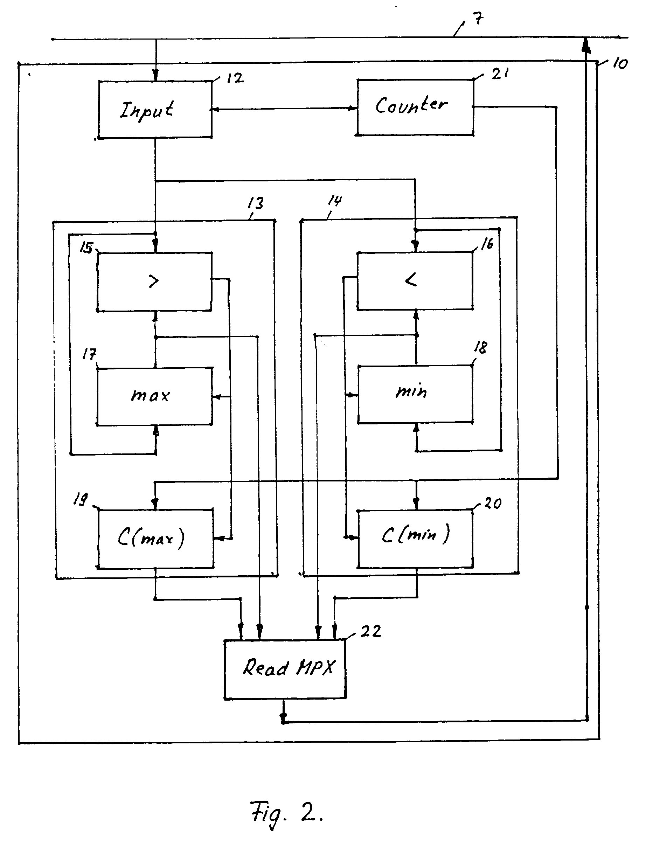

Referring now to Fig.2, the max-min calculator 10 grabs the data on the fly off the data bus 7 if an appropriate control bit appears on the load input of input register 12, and carries out parallel comparisons of the inputted value with the current maximum and the current minimum in max- and mincalculators 13 and 14. If the inputted value represents a new maximum or a new minimum the comparator 15 or 16 sends a load signal to the corresponding max-register 17 or min-register 18 to update the current minimum and maximum. In a further preferred embodiment, event registers 19 and 20 are loaded with the contents of an event counter 21, whenever the corresponding max-register 17 or min-register 18 is updated. When all L values of $G_j$ have been read and compared, the contents of the max-register 17 and the min-register 18 are written through the read-out multiplexer 22 across the data bus 7 into the j-th location pair of the auxiliary memory 11. Optionally, the contents of the event registers 19 and 20 can be read out to a further auxiliary memory. Their availability can be used to improve the selection of $e_j$ and the display of the signal in certain cases.

The implementation of the max-min comparator is preferably carried out in silicon technology (integrated circuits, gate arrays, etc.) to obtain the desired operational speed for handling large blocks of original time series data. If speed is less important a microprocessor implementation is also possible.

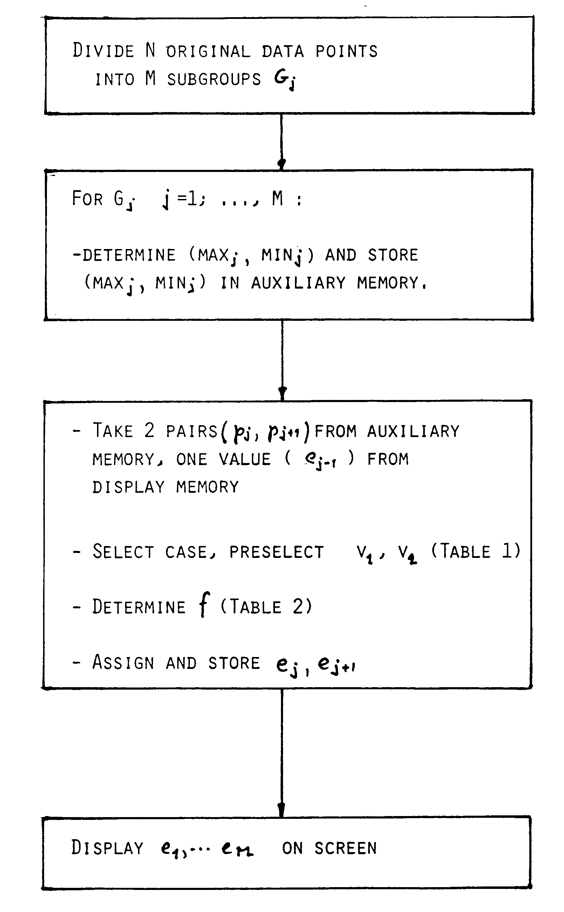

As shown in the method flow diagram of Fig. 3, after the subdivision of the N original data points into M subgroups $G_j$, the max-min determination is carried out for all M data groups $G_j$, $j = 1,...,M$, until the M pairs of a max- and a min-value each are stored in the auxiliary memory 11.

In the shown preferred method, $k1 = 2$ and $k2 = 1$, i.e. at a given point of the iteration of the selection step the two pairs $(max_i, min_i)$ and $(max_{i+1}, min_{i+1})$ and the most recently stored value $e_{i-1}$ are read to determine $e_i$ and $e_{i+1}$ (for $i = 0$, $e_0$ is set equal to the first data value).

This is done by first selecting one of six cases, each case representing one of the six possible relative positions of the four values $max_i, min_i$, and $max_{i+1}, min_{i+1}$. Table 1 lists the six cases, the corresponding conditions, and the preselection of two values, v1 and v2. Since they always correspond to extreme values, the displaying of extremes of a signal is always assured.

Table 1

| Case k | Condition | Preselection v1,v2 |
|--------|-----------|--------------------|
| 1 | $max_i \geq min_i \geq max_{i+1} \geq min_{i+1}$ | $max_i$, $min_{i+1}$ |
| 2 | $max_i \geq max_{i+1} \geq min_i \geq min_{i+1}$ | $max_i$, $min_{i+1}$ |
| 3 | $max_{i+1} \geq max_i \geq min_i \geq min_{i+1}$ | $min_{i+1}$, $max_{i+1}$ |
| 4 | $max_i \geq max_{i+1} \geq min_{i+1} \geq min_i$ | $min_i$, $max_i$ |
| 5 | $max_{i+1} \geq max_i \geq min_{i+1} \geq min_i$ | $min_i$, $max_{i+1}$ |
| 6 | $max_{i+1} \geq min_{i+1} \geq max_i \geq min_i$ | $min_i$, $max_{i+1}$ |

This preselection of v1 and v2 and the subsequent determination of their order take into consideration that a number of typical waveforms should be properly displayed:
- a monotonous (single slope) signalform
- a single local extremum, either maximum or minimum
- a single positive or negative step function

Cases with multiple extrema are less important, since the preselection of v1 and v2 guarantees that at least the most extreme excursions are caught, their exact number and order are less important.

In a second step, it is determined in which order the preselected values v1 and v2 will be assigned to location $e_i$ and $e_{i+1}$. This is done in function of a logical variable f (for each of the six cases), such that

$$e_i = v1^*f + v2^*f'$$
$$e_{i+1} = v1^*f' + v2^*f$$

where the prime $(')$ signifies the logical complement.

The logical function f is determined according to Table 2.

Table 2

| Case | Logical function f | where |
|------|--------------------|-------|
| 1 | 1 | |
| 2 | 1 | |
| 3 | $DB + DA' + A'C'$ | $D = e_{i-1} \geq (max_i + min_i)/2$<br>$A = min_i - min_{i+1} \geq max_{i+1} - max_i$<br>$B = max_i - min_i \geq min_i - min_{i+1}$<br>$C = max_i - min_i \geq max_{i+1} - max_i$ |
| 4 | $D'B + D'A' + A'C'$ | $D$ as above<br>$A$ as above<br>$B = max_{i+1} - min_{i+1} \geq max_i - max_{i+1}$<br>$C = max_{i+1} - min_{i+1} \geq min_{i+1} - min_i$ |
| 5 | 1 | |
| 6 | 1 | |

In a variation of the method, for cases 1 and 2, as well as for cases 5 and 6, the assignment of the value $e_i$ is made dependent on the value of $e_{i-1}$, in order to produce a smoother signal display:
For cases 1 and 2, if $e_{i-1} \geq max_i$, $e_i = min_i$.
For cases 5 and 6, if $e_{i-1} \leq min_i$, $e_i = max_i$.

The determination of $e_{i+1}$ remains unchanged.

The selector step is carried out in the selector 6 which can be implemented in conventional logical circuitry, the functions of tables 1 and 2 being implemented in a first and a second logical unit, or as a software implementation on a microprocessor.

**Claims**

1. Method for compacting original digital time series data comprising N data points for display on a display screen (3) of a digital oscilloscope, the screen (3) having a horizontal resolution of M, where N is a multiple of M, characterized by the steps of
   - grouping the original N data points in an acquisition memory (2) into M groups $G_j$, j = 1,...,M, of L contiguous data points each, where M*L = N,
   - determining for each group $G_j$ the maximum and minimum values, $max_j$ and $min_j$, and storing them as a pair of values $p_j$ in an auxiliary memory (11),
   - selecting from the M pairs $p_j$, j = 1,...,M in the auxiliary memory (11) M display values $e_j$, j = 1,...,M, for storage in a display image memory (4) and for display on the M resolution display screen (3), so that the M values include all extreme value excursions of the original data and represent the original signal essentially undistorted.

2. Method according to claim 1, characterized in that the selecting consists of
   - iteratively considering the values of k1 pairs of max/min values, $p_i,...,p_{i+k1-1}$, where k1 is at least 2, from the auxiliary memory (11) and of k2 of the most recently stored display values $e_{i-k2},...,e_{i-1}$, in the display image memory (4) where k2 is at least 1,
   - choosing, based thereon, k1 display variables, $e_i,...,e_{i+k1-1}$ from the 2*k1 values read from auxiliary memory (11) and storing them in the display image memory (4),
   - repeating these steps until the display image memory (4) is filled.

3. Method according to claim 2, characterized in that k1 = 2 and k2 = 1 and that the choosing consists of
   - determining which case of Table 1 applies and preselecting two values v1 and v2,

Table 1

| Case k | Condition | Preselection v1,v2 |
|--------|-----------|---------------------|
| 1 | $max_i \geq min_i \geq max_{i+1} \geq min_{i+1}$ | $max_i, min_{i+1}$ |
| 2 | $max_i \geq max_{i+1} \geq min_i \geq min_{i+1}$ | $max_i, min_{i+1}$ |
| 3 | $max_{i+1} \geq max_i \geq min_i \geq min_{i+1}$ | $min_{i+1}, max_{i+1}$ |
| 4 | $max_i \geq max_{i+1} \geq min_{i+1} \geq min_i$ | $min_i, max_i$ |
| 5 | $max_{i+1} \geq max_i \geq min_{i+1} \geq min_i$ | $min_i, max_{i+1}$ |
| 6 | $max_{i+1} \geq min_{i+1} \geq max_i \geq min_i$ | $min_i, max_{i+1}$ |

   - determining for the applicable case, based on the values of $e_{i+1}$, $max_i$, $min_i$, $max_{i+1}$, $min_{i+1}$, a logical function f according to Table 2,

Table 2

| Case | Logical function f | where |
|------|--------------------|-------|
| 1 | 1 | |
| 2 | 1 | |
| 3 | DB + DA' + A'C' | D = $e_{i-1} \geq (max_i + min_i)/2$<br>A = $min_i - min_{i+1} \geq max_{i+1} - max_i$<br>B = $max_i - min_i \geq min_i - min_{i+1}$<br>C = $max_i - min_i \geq max_{i+1} - max_i$ |
| 4 | D'B + D'A' + A'C' | D as above<br>A as above<br>B = $max_{i+1} - min_{i+1} \geq max_i - max_{i+1}$<br>C = $max_{i+1} - min_{i+1} \geq min_{i+1} - min_i$ |
| 5 | 1 | |
| 6 | 1 | |

- assigning $e_i$ = f*vl + f'*v2 and $e_{i+1}$ = f'*vl + f*v2.

**4.** Method according to claim 3, characterized in that for cases, 1,2,5 and 6, instead of using f = 1, the following logic is used for determining $e_i$ :

| Case | Condition | Assignment |
|------|-----------|------------|
| 1,2 | if $e_{i-1} \geq max_i$ | then $e_i$ = $min_i$ |
| 5,6 | if $e_{i-1} \leq min_i$ | then $e_i$ = $max_i$ |

**5.** Apparatus in a digital oscilloscope for compacting original digital time series data comprising N data points for displaying on a display screen (3) of the digital oscilloscope of horizontal resolution M where N is a multiple of M, comprising a data acquisition memory (2), data compaction means (5), a display image memory (4) and the display screen (3), characterized in that the data compaction means (5) comprises a control unit (9), a max-min calculator (10) to determine maxima and minima of M subgroups of the N data in the data acquisition memory (2), an auxiliary memory (11) for storing pairwise the maximum and the minimum of each subgroup, and a selector means (6) for iteratively selecting from the M pairs in the auxiliary memory (11) M display values to be stored in the display image memory (4), so that the M values include all extreme value excursions of the original data and represent the original signal essentially undistorted, the max-min calculator (10), the auxiliary memory (11) and the selector means (6) being connected over a data bus (7) and a control bus (8) to each other and to the data acquisition memory (2) and the display image memory (4), the control unit (9) being connected to the control bus (8).

**6.** Apparatus according to claim 5, characterized in that the max-min calculator (10) comprises an input register (12), said input register (12) reading data from the data bus (7) and passing it to a max-calculator (13) and a min-calculator (14), the max-calculator (13) comprising a comparator (15) and a max-register (17) which is updated when the comparator (15) determines a new maximum, the min-calculator (14) comprising a comparator (16) and a min-register (18) which is updated when the comparator determines a new minimum, the max- and min-registers (17, 18) being connected to a read-out multiplexer (22) which passes the maximum and the minimum to the auxiliary memory (11).

**7.** Apparatus according to claim 6, characterized in that it further comprises a data counter (21) connected to two event registers (19, 10) in the max- and min-calculators (13, 14) in order to register for which data count the maximum and the minimum occur, the event registers (19, 20) being connected to the read-out multiplexer (22) for passing the contents to a further auxiliary memory.

8. Apparatus according to one of the claim 5-7, characterized in that the selector means (6) comprises logical circuits implementing the functions of Table 1 and Table 2, to assign values $e_i$ and $e_{i+1}$, based on $p_i$ and $p_{i+1}$, where $e_j$, $j = 1,...,M$, is the j-th value in the display image memory (4), and $p_j = (max_j, min_j)$ $j = 1,...,M$, the j-th pair of values in the auxiliary memory (11), Table 1 defining the unique case number k and the corresponding v1 and v2 which correspond to $p_i$ and $p_{i+1}$, and Table 2 defining a logical function f based on k, $p_i$, $p_{i+1}$ and $e_{i-1}$, where $e_i$ and $e_{i+1}$ are given by

$e_i$ = f*v1 + f'*v2 and
$e_{i+1}$ = f'*vl + f*v2.

Table 1

| Case k | Condition | Preselection v1,v2 |
|---|---|---|
| 1 | $max_i \geq min_i \geq max_{i+1} \geq min_{i+1}$ | $max_i, min_{i+1}$ |
| 2 | $max_i \geq max_{i+1} \geq min_i \geq min_{i+1}$ | $max_i, min_{i+1}$ |
| 3 | $max_{i+1} \geq max_i \geq min_i \geq min_{i+1}$ | $min_{i+1}, max_{i+1}$ |
| 4 | $max_i \geq max_{i+1} \geq min_{i+1} \geq min_i$ | $min_i, max_i$ |
| 5 | $max_{i+1} \geq max_i \geq min_{i+1} \geq min_i$ | $min_i, max_{i+1}$ |
| 6 | $max_{i+1} \geq min_{i+1} \geq max_i \geq min_i$ | $min_i, max_{i+1}$ |

Table 2

| Case | Logical function f | where |
|---|---|---|
| 1 | 1 | |
| 2 | 1 | |
| 3 | DB + DA' + A'C' | $D = e_{i-1} \geq (max_i + min_i)/2$<br>$A = min_i - min_{i+1} \geq max_{i+1} - max_i$<br>$B = max_i - min_i \geq min_i - min_{i+1}$<br>$C = max_i - min_i \geq max_{i+1} - max_i$ |
| 4 | D'B + D'A' + A'C' | D as above<br>A as above<br>$B = max_{i+1} - min_{i+1} \geq max_i - max_{i+1}$<br>$C = max_{i+1} - min_{i+1} \geq min_{i+1} - min_i$ |
| 5 | 1 | |
| 6 | 1 | |

9. Apparatus according to one of the claims 5-7, characterized in that the selector means (6) is implemented by a microprocessor.

10. Apparatus according to claims 5-9, characterized in that the max-min calculator (10) is implemented by a microprocessor.

11. Apparatus according to claims 5-9, characterized in that the max-min calculator (10) is implemented by silicon technology.

**Patentansprüche**

1. Verfahren zur Kompression ursprünglich digitaler zeitserieller Daten, welche N Datenpunkte zur Anzeige auf einem Monitor (3) eines Digital-Oszilloskops umfassen, wobei der Monitor (3) eine horizontale Auflösung von M hat und wobei N ein Vielfaches von M ist, **gekennzeichnet durch**
   - das Gruppieren der ursprünglichen N Datenpunkte in einem Datenerfassungsspeicher (2) in M Gruppen $G_j$, $j = 1, ..., M$, von jeweils L fortlaufenden Datenpunkten, wobei M*L = N

- das Bestimmen der Maximum- und Minimum-Werte $max_j$ und $min_j$ für jede Gruppe $G_j$ und das Abspeichern dieser als Wertepaar $p_j$ in einem Hilfsspeicher (11),
- das Auswählen von M Anzeigewerten $p_j$, j = 1, ..., M, aus den M Paaren $p_j$, j = 1, ..., M in dem Hilfsspeicher (11) zur Abspeicherung in einem Anzeigebildspeicher (4) und zur Anzeige auf dem Monitor (3) mit der Auflösung M, so daß die M Werte alle extremen Wertausschläge der ursprünglichen Daten einschließen und das ursprüngliche im wesentlichen unverzerrte Signal darstellen.

2. Verfahren nach Anspruch 1, **dadurch gekennzeichnet,** daß die Auswahl folgende Schritte umfaßt:
- das interative Berücksichtigen der Werte von k1 Paaren von Max-/Min-Werten, $p_i$, ..., $p_{i+k1-1}$, wobei k1 wenigstens 2 beträgt, aus dem Hilfsspeicher (11) und von k2 der zuletzt gespeicherten Anzeigewerte $e_{i-k2}$, ..., $e_{i-1}$, in dem Anzeigebildspeicher (4), wobei k2 wenigstens 1 beträgt,
- das Auswählen, darauf basierend, von k1 Anzeigevariablen, $e_i$, ..., $e_{i+k1-1}$ aus den 2*k1 Werten, welche von dem Hilfsspeicher (11) gelesen wurden, und das Abspeichern dieser in dem Anzeigebildspeicher (4),
- das Wiederholen dieser Schritte solange, bis der Anzeigebildspeicher (4) gefüllt ist.

3. Verfahren nach Anspruch 2, **dadurch gekennzeichnet,** daß k1 2 entspricht und k2 1 entspricht und daß die Auswahl aus folgenden Schritten besteht:
- das Bestimmen, welcher Fall von Tabelle 1 angewendet wird und das Vorauswählen zweier Werte v1 und v2,

Tabelle 1

| Fall k | Bedingung | Vorauswahl v1,v2 |
|--------|-----------|------------------|
| 1 | $max_i \geq min_i \geq max_{i+1} \geq min_{i+1}$ | $max_i$, $min_{i+1}$ |
| 2 | $max_i \geq max_{i+1} \geq min_i \geq min_{i+1}$ | $max_i$, $min_{i+1}$ |
| 3 | $max_{i+1} \geq max_i \geq min_i \geq min_{i+1}$ | $min_{i+1}$, $max_{i+1}$ |
| 4 | $max_i \geq max_{i+1} \geq min_{i+1} \geq min_i$ | $min_i$, $max_i$ |
| 5 | $max_{i+1} \geq max_i \geq min_{i+1} \geq min_i$ | $min_i$, $max_{i+1}$ |
| 6 | $max_{i+1} \geq min_{i+1} \geq max_i \geq min_i$ | $min_i$, $max_{i+1}$ |

- das Bestimmen einer logischen Funktion f entsprechend der Tabelle 2 für den anwendbaren Fall, basierend auf den Werten von $e_{i-1}$, $max_i$, $min_i$, $max_{i+1}$, $min_{i+1}$,

| Fall | logische Funktion f | wobei |
|------|---------------------|-------|
| 1 | 1 | |
| 2 | 1 | |
| 3 | DB + DA' + A'C' | D = $e_{i-1} \geq (max_i + min_i)/2$<br>A = $min_i - min_{i+1} \geq max_{i+1} - max_i$<br>B = $max_i - min_i \geq min_i - min_{i+1}$<br>C = $max_i - min_i \geq max_{i+1} - max_i$ |
| 4 | D'B + D'A' + A'C' | D wie oben<br>A wie oben<br>B = $max_{i+1} - min_{i+1} \geq max_i - max_{i+1}$<br>C = $max_{i+1} - min_{i+1} \geq min_{i+1} - min_i$ |
| 5 | 1 | |
| 6 | 1 | |

- das Zuweisen $e_i$ = f*vl + f'*v2 und $e_{i+1}$ = f'*vl + f*v2.

4. Verfahren nach Anspruch 3, **dadurch gekennzeichnet,** daß für die Fälle 1, 2, 5 und 6 anstelle der Verwendung von f = 1 die folgende Logik zur Bestimmung von $e_i$ verwendet wird:

| Fall | Bedingung | Zuordnung |
|------|-----------|-----------|
| 1,2 | wenn $e_{i-1} \geq max_i$ | dann $e_i = min_i$ |
| 5,6 | wenn $e_{i-1} \leq min_i$ | dann $e_i = max_i$ |

5. Einrichtung in einem Digital-Oszilloskop zur Kompression ursprünglicher digitaler zeitserieller Daten, welche N Datenpunkte zur Anzeige auf einem Monitor (3) des Digital-Oszilloskops mit einer horizontalen Auflösung M umfaßt, wobei N eine Vielzahl von M beträgt, mit einem Datenerfassungsspeicher (2), einer Datenkompressionseinrichtung (5), einem Anzeigebildspeicher (4) und einem Monitor (3), **dadurch gekennzeichnet,** daß die Datenkompressionseinrichtung (5) eine Steuereinheit (9), einen Max-/Min-Rechner (10) zur Bestimmung der Maxima und Minima von M Untergruppen der N Daten in dem Datenerfassungsspeicher (2), einen Hilfsspeicher (11) zur paarweisen Speicherung des Maximums und Minimums jeder Untergruppe und einer Auswahleinrichtung (6) zur iterativen Auswahl von M in dem Anzeigebildspeicher (4) zu speichernden Anzeigewerten aus den M Paaren in dem Hilfsspeicher (11) umfaßt, so daß die M Werte alle extremen Wertausschläge der ursprünglichen Daten umfassen und das im wesentlichen unverzerrte ursprüngliche Signal darstellen, wobei der Max-/Min-Rechner (10), der Hilfsspeicher (11) und die Auswahleinrichtung (6) über einen Datenbus (7) und einen Steuerbus (8) miteinander und mit dem Datenerfassungsspeicher (2) verbunden sind und der Anzeigebildspeicher (4) und die Steuereinheit (9) mit dem Steuerbus (8) verbunden sind.

6. Einrichtung nach Anspruch 5, **dadurch gekennzeichnet,** daß der Max-/Min-Rechner (10) einen Eingabespeicher (12) umfaßt, der Eingabespeicher (12) die Daten von dem Datenbus (7) liest und sie an einen Max-Rechner (13) und einen Min-Rechner (14) weiterleitet, wobei der Max-Rechner (13) einen Vergleicher (15) und ein Max-Register (17) umfaßt, welches aktualisiert wird, wenn der Vergleicher (15) ein neues Maximum bestimmt, der Min-Rechner (14) einen Vergleicher (16) und ein Min-Register (18) umfaßt, welches aktualisiert wird, wenn der Vergleicher ein neues Minimum bestimmt, die Max- und Min-Register (17, 18) mit einer Auslesedatenübertragungssteuereinheit verbunden sind, die das Maximum und das Minimum an den Hilfsspeicher (11) weiterleitet.

7. Einrichtung nach Anspruch 6, **dadurch gekennzeichnet,** daß sie weiterhin einen Datenzähler (21) umfaßt, welcher mit zwei Ereignisregistern (19, 10) in den Max- und Min-Rechnern (13, 14) verbunden ist, um zu speichern für welche Datenzählung das Maximum und das Minimum auftreten, wobei die Ereignisregister (19, 20) mit einer Auslesedatenübertragungssteuereinheit (22) verbunden sind, um die Inhalte einem weiteren Hilfsspeicher zuzuführen.

8. Einrichtung nach einem der Ansprüche 5 bis 7, **dadurch gekennzeichnet,** daß die Auswahleinrichtung (6) logische Schaltungen umfaßt, welche die Funktionen der Tabellen 1 und 2 ausführen, um die Werte $e_i$ und $e_{i+1}$, basierend auf $p_i$ und $p_{i+1}$ dem j-en Wertepaar in dem Hilfsspeicher (11) zuzuordnen, wobei $e_j$, j = 1, ..., M, der j-te Wert im Anzeigebildspeicher (4) ist und $p_j = (max_j, min_j)$ j = 1, ..., M, Tabelle 1 die einmalige Fallnummer und die entsprechenden v1 und v2 bestimmt, welche $p_i$ und $p_{i+1}$ entsprechen, und Tabelle 2 eine logische Funktion f bestimmt, welche auf k, $p_i$, $p_{i+1}$ und $e_{i-1}$ basiert, wobei $e_i$ und $e_{i+1}$ durch

$e_i = f^*v1 + f'^*v2$ und

$e_{i+1} = f'^*v1 + f^*v2$

gegeben sind.

Tabelle 1

| Fall k | Bedingung | Vorauswahl v1,v2 |
|--------|-----------|------------------|
| 1 | $max_i \geq min_i \geq max_{i+1} \geq min_{i+1}$ | $max_i, min_{i+1}$ |
| 2 | $max_i \geq max_{i+1} \geq min_i \geq min_{i+1}$ | $max_i, min_{i+1}$ |
| 3 | $max_{i+1} \geq max_i \geq min_i \geq min_{i+1}$ | $min_{i+1}, max_{i+1}$ |
| 4 | $max_i \geq max_{i+1} \geq min_{i+1} \geq min_i$ | $min_i, max_i$ |
| 5 | $max_{i+1} \geq max_i \geq min_{i+1} \geq min_i$ | $min_i, max_{i+1}$ |
| 6 | $max_{i+1} \geq min_{i+1} \geq max_i \geq min_i$ | $min_i, max_{i+1}$ |

Tabelle 2

| Fall | logische Funktion f | wobei |
|------|---------------------|-------|
| 1 | 1 | |
| 2 | 1 | |
| 3 | $DB + DA' + A'C'$ | $D = e_{i-1} \geq (max_i + min_i)/2$<br>$A = min_i - min_{i+1} \geq max_{i+1} - max_i$<br>$B = max_i - min_i \geq min_i - min_{i+1}$<br>$C = max_i - min_i \geq max_{i+1} - max_i$ |
| 4 | $D'B + D'A' + A'C'$ | D wie oben<br>A wie oben<br>$B = max_{i+1} - min_{i+1} \geq max_i - max_{i+1}$<br>$C = max_{i+1} - min_{i+1} \geq min_{i+1} - min_i$ |
| 5 | 1 | |
| 6 | 1 | |

**9.** Einrichtung nach einem der Ansprüche 5 bis 7, **dadurch gekennzeichnet,** daß die Auswahleinrichtung (6) durch einen Mikroprozessor verwirklicht ist.

**10.** Einrichtung nach den Ansprüchen 5 bis 9, **dadurch gekennzeichnet,** daß der Max-/Min-Rechner (10) durch einen Mikroprozessor verwirklicht ist.

**11.** Einrichtung nach den Ansprüchen 5 bis 9, **dadurch gekennzeichnet,** daß der Max-/Min-Rechner (10) durch Siliziumtechnik verwirklicht ist.

## Revendications

**1.** Procédé pour comprimer une série chronologique de données numériques d'origine, comprenant N points de données pour affichage sur un écran de visualisation (3) d'un oscilloscope numérique, l'écran (3) ayant une résolution horizontale (M), N étant un multiple de M, caractérisé par les étapes suivantes :
- grouper les N points de données d'origine dans une mémoire d'acquisition (2) en M groupes $G_j$, $j = 1, ..., M$, de L points de données contigus chacun, $M \times L = N$,
- déterminer pour chaque groupe $G_j$ les valeurs maximale et minimale, $max_j$ et $min_j$, et les stocker en tant que paires de valeurs $p_j$ dans une mémoire auxiliaire (11),
- sélectionner parmi les M paires $p_j$, $j = 1, ..., M$ dans la mémoire auxiliaire (11) M valeurs d'affichage $e_j$, $j = 1, ..., M$, pour stockage dans une mémoire d'images d'affichage (4) et pour affichage sur l'écran de visualisation de résolution M (3), de telle sorte que les M valeurs comprennent toutes les excursions de valeurs extrêmes des données d'origine et représentent le signal d'origine essentiellement non déformé.

**2.** Procédé selon la revendication 1, caractérisé en ce que la sélection consiste à :
- considérer par itération les valeurs de k1 paires de valeurs maxi-mini, $p_i, ..., p_{i+k1-1}$, k1 étant au

moins égal à 2, en provenance de la mémoire auxiliaire (11) et de k2 des valeurs d'affichage les plus récemment stockées $e_{i-k2}$, ..., $e_{i-1}$, dans la mémoire d'images d'affichage (4), k2 étant au moins égal à 1,

- choisir, sur la base de ces valeurs, k1 variables d'affichage $e_i$, ..., $e_{i+k1-1}$ parmi les 2 x k1 valeurs extraites de la mémoire auxiliaire (11) et les stocker dans la mémoire d'images d'affichage (4), et
- répéter ces stades jusqu'à ce que la mémoire d'images d'affichage (4) soit remplie.

3. Procédé selon la revendication 2, caractérisé en ce que k1 = 2 et k2 = 1 et en ce que le choix consiste à :

- déterminer quel cas du Tableau 1 s'applique et présélectionner deux valeurs v1 et v2,

Tableau 1

| Cas k | Condition | Présélection v1,v2 |
|---|---|---|
| 1 | $max_i \geq min_i \geq max_{i+1} \geq min_{i+1}$ | $max_i, min_{i+1}$ |
| 2 | $max_i \geq max_{i+1} \geq min_i \geq min_{i+1}$ | $max_i, min_{i+1}$ |
| 3 | $max_{i+1} \geq max_i \geq min_i \geq min_{i+1}$ | $min_{i+1}, max_{i+1}$ |
| 4 | $max_i \geq max_{i+1} \geq min_{i+1} \geq min_i$ | $min_i, max_i$ |
| 5 | $max_{i+1} \geq max_i \geq min_{i+1} \geq min_i$ | $min_i, max_{i+1}$ |
| 6 | $max_{i+1} \geq min_{i+1} \geq max_i \geq min_i$ | $min_i, max_{i+1}$ |

- déterminer pour le cas applicable, sur la base des valeurs de $e_{i-1}$, $max_i$, $min_i$, $max_{i+1}$, $min_{i+1}$, une fonction logique f en fonction du Tableau 2,

Tableau 2

| Cas | Fonction logique f | où |
|---|---|---|
| 1 | 1 | |
| 2 | 1 | |
| 3 | DB + DA' + A'C' | $D = e_{i-1} \geq (max_i + min_i)/2$<br>$A = min_i - min_{i+1} \geq max_{i+1} - max_i$<br>$B = max_i - min_i \geq min_i - min_{i+1}$<br>$C = max_i - min_i \geq max_{i+1} - max_i$ |
| 4 | D'B + D'A' + A'C' | D comme ci-dessus<br>A comme ci-dessus<br>$B = max_{i+1} - min_{i+1} \geq max_i - max_{i+1}$<br>$C = max_{i+1} - min_{i+1} \geq min_{i+1} - min_i$ |
| 5 | 1 | |
| 6 | 1 | |

- et affecter $e_i$ = fxv1 + f'xv2 et $e_{i+1}$ = f'xv1 + f'xv2.

4. Procédé selon la revendication 3, caractérisé en ce que, pour les cas 1, 2, 5 et 6, au lieu d'utiliser f = 1, on utilise la logique suivante pour déterminer $e_i$ :

| Cas | Condition | Affectation |
|---|---|---|
| 1,2 | si $e_{i-1} \geq max_i$ | alors $e_i = min_i$ |
| 5,6 | si $e_{i-1} \leq min_i$ | alors $ei = max_i$ |

5. Dispositif dans un oscilloscope numérique pour comprimer une série chronologique de données numériques d'origine comprenant N points de données à afficher sur un écran de visualisation (3) de l'oscilloscope numérique ayant une résolution horizontale M , N étant un multiple de M, comprenant une mémoire d'acquisition de données (2), des moyens de compression des données (5), une mémoire d'images d'affichage (4) et l'écran de visualisation (3), caractérisé en ce que les moyens de compression des données (5) comprennent une unité de commande (9), un calculateur de maxi-mini (10) pour déterminer les maxima et les minima de M sous-groupes des N données dans la mémoire d'acquisition de données (2), une mémoire auxiliaire (11) pour stocker par paires le maximum et le minimum de chaque sous-groupe, et des moyens de sélection (6) pour sélectionner par itération parmi les M paires dans la mémoire auxiliaire (11) M valeurs d'affichage stockées dans la mémoire d'images d'affichage (4), de façon que les M valeurs comportent toutes les excursions de valeurs extrêmes des données d'origine et représentent le signal d'origine essentiellement non déformé, le calculateur de maxi-mini (10), la mémoire auxiliaire (11) et les moyens de sélection (6) étant reliés l'un à l'autre par un bus de données (7) et un bus de commande (8) et à la mémoire d'acquisition des données (2) et à la mémoire d'images d'affichage (4), l'unité de commande (9) étant raccordée au bus de commande (8).

6. Dispositif selon la revendication 5, caractérisé en ce que le calculateur de maxi-mini (10) comprend un registre d'entrée (12), ce registre d'entrée (12) extrayant des données du bus de données (7) et les transmettant à un calculateur de maxi (13) et à un calculateur de mini (14), le calculateur de maxi (13) comprenant un comparateur (15) et un registre de maxi (17) qui est actualisé lorsque le comparateur (15) détermine un nouveau maximum, le calculateur de mini (14) comprenant un comparateur (16) et un registre de mini (18) qui est actualisé lorsque le comparateur détermine un nouveau minimum, les registres de maxi et de mini (17,18) étant raccordés à un multiplexeur de lecture (22) qui transmet le maximum et le minimum à la mémoire auxiliaire (11).

7. Dispositif selon la revendication 6, caractérisé en ce qu'il comporte en outre un compteur de données (21) raccordé à deux registres d'événements (19,20) dans les calculateurs de maxi et de mini (13,14) afin d'enregistrer pour quel compte de données le maximum et le minimum surviennent, les registres d'événements (19,20) étant raccordés au multiplexeur de lecture (22) pour transmettre leur contenu à une autre mémoire auxiliaire.

8. Dispositif selon l'une des revendications 5 à 7, caractérisé en ce que les moyens de sélection (6) comprennent des circuits logiques mettant en oeuvre les fonctions du Tableau 1 et du Tableau 2 pour assigner les valeurs $e_i$ et $e_{i+1}$, sur la base de $p_i$ et $p_{i+1}$, dans lesquelles $e_j$, j = 1, ..., M, est la jième valeur dans la mémoire d'images d'affichage (4) et $pj = (max_j, min_j)$, j = 1, ..., M, la jième paire de valeurs dans la mémoire auxiliaire (11), le Tableau 1 définissant l'unique numéro de cas k et les valeurs v1 et v2 correspondantes qui correspondent à $p_i$ et $p_{i+1}$, le Tableau 2 définissant une fonction logique f sur la base de k, $p_i$, $p_{i+1}$ et $e_{i-1}$, $e_i$ et $e_{i+1}$ étant donnés par :

$$e_i = fxv1 + f'xv2 \text{ et}$$
$$e_{i+1} = f'xv1 + fxv2$$

Tableau 1

| Cas k | Condition | Présélection v1,v2 |
|---|---|---|
| 1 | $max_i \geq min_i \geq max_{i+1} \geq min_{i+1}$ | $max_i, min_{i+1}$ |
| 2 | $max_i \geq max_{i+1} \geq min_i \geq min_{i+1}$ | $max_i, min_{i+1}$ |
| 3 | $max_{i+1} \geq max_i \geq min_i \geq min_{i+1}$ | $min_{i+1}, max_{i+1}$ |
| 4 | $max_i \geq max_{i+1} \geq min_{i+1} \geq min_i$ | $min_i, max_i$ |
| 5 | $max_{i+1} \geq max_i \geq min_{i+1} \geq min_i$ | $min_i, max_{i+1}$ |
| 6 | $max_{i+1} \geq min_{i+1} \geq max_i \geq min_i$ | $min_i, max_{i+1}$ |

Tableau 2

| Case | Fonction logique f | où |
|------|--------------------|-----|
| 1<br>2 | 1<br>1 | |
| 3 | DB + DA' + A'C' | $D = e_{i-1} \geqq (max_i + min_i)/2$<br>$A = min_i - min_{i+1} \geqq max_{i+1} - max_i$<br>$B = max_i - min_i \geqq min_i - min_{i+1}$<br>$C = max_i - min_i \geqq max_{i+1} - max_i$ |
| 4 | D'B + D'A' + A'C' | D comme ci-dessus<br>A comme ci-dessus<br>$B = max_{i+1} - min_{i+1} \geqq max_i - max_{i+1}$<br>$C = max_{i+1} - min_{i+1} \geqq min_{i+1} - min_i$ |
| 5<br>6 | 1<br>1 | |

**9.** Dispositif selon l'une des revendications 5 à 7, caractérisé en ce que les moyens de sélection (6) sont réalisés sous forme de microprocesseur.

**10.** Dispositif selon les revendications 5 à 9, caractérisé en ce que le calculateur de maxi-mini (10) est réalisé sous forme de microprocesseur.

**11.** Dispositif selon les revendications 5 à 9, caractérisé en ce que le calculateur de maxi-mini (10) est réalisé par la technologie du silicium.

Fig. 1

Fig. 2.

15

DIVIDE N ORIGINAL DATA POINTS
INTO M SUBGROUPS $G_j$

FOR $G_j$  $j=1, ..., M$ :

-DETERMINE $(MAX_j, MIN_j)$ AND STORE
$(MAX_j, MIN_j)$ IN AUXILIARY MEMORY.

- TAKE 2 PAIRS $(p_j, p_{j+1})$ FROM AUXILIARY
  MEMORY, ONE VALUE $(e_{j-1})$ FROM
  DISPLAY MEMORY

- SELECT CASE, PRESELECT  $V_1, V_2$ (TABLE 1)

- DETERMINE $f$ (TABLE 2)

- ASSIGN AND STORE $e_j, e_{j+1}$

DISPLAY $e_1, ... e_m$  ON SCREEN

FIG. 3